**Europäisches Patentamt**

**European Patent Office**

**Office européen des brevets**

(19)

(11) Veröffentlichungsnummer: **0 033 507**
**A2**

(12) # EUROPÄISCHE PATENTANMELDUNG

(21) Anmeldenummer: **81100557.8**

(22) Anmeldetag: **26.01.81**

(51) Int. Cl.³: **H 01 L 49/02**

(30) Priorität: **05.02.80 DE 3004149**

(43) Veröffentlichungstag der Anmeldung:
**12.08.81 Patentblatt 81/32**

(84) Benannte Vertragsstaaten:
**CH FR GB IT LI NL**

(71) Anmelder: **SIEMENS AKTIENGESELLSCHAFT Berlin und München**
**Postfach 22 02 61**
**D-8000 München 22(DE)**

(72) Erfinder: **Hieber, Konrad, Dr.**
**Aiblingerstrasse 3**
**D-8000 München 19(DE)**

(72) Erfinder: **Mayer, Norbert, Dr.**
**Höglwörtherstrasse 216**
**D-8000 München 70(DE)**

(54) **Verfahren zur reproduzierbaren Herstellung metallischer Schichten.**

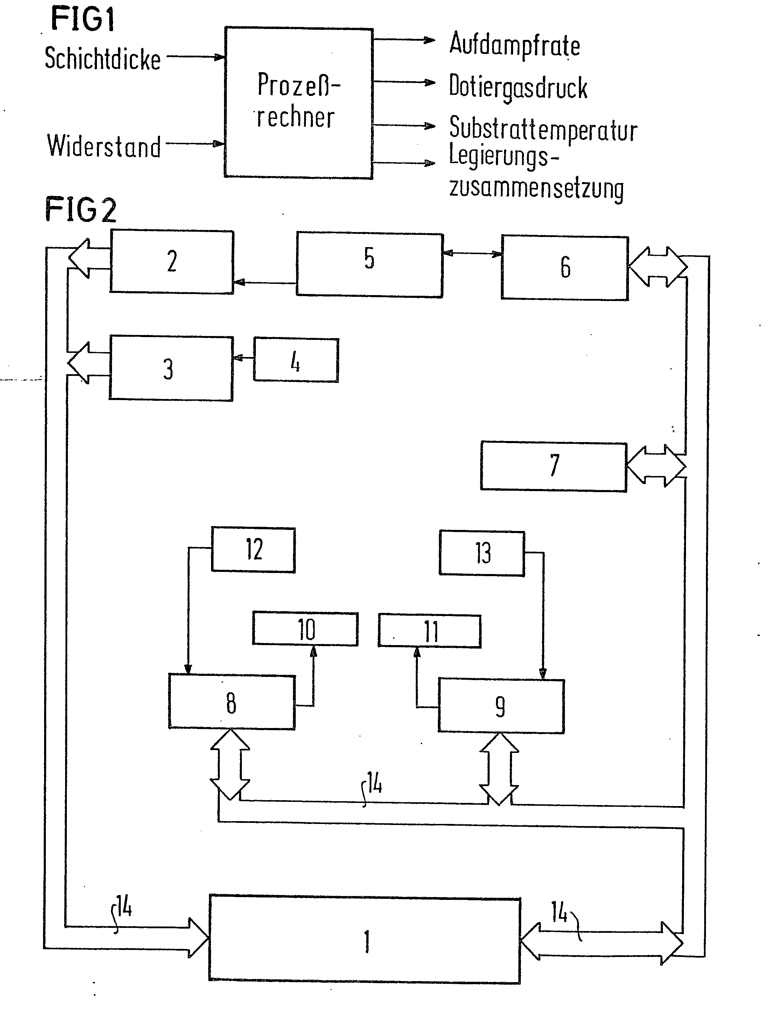

(57) Die Erfindung betrifft ein Verfahren zur reproduzierbaren Herstellung metallischer Schichten durch Steuerung des Beschichtungsprozesses, wobei der spezifische elektrische Widerstand $\rho$ in Abhängigkeit von der Schichtdicke d bestimmt wird. Dabei werden die für das Wachstum der Schicht bezüglich ihrer Struktur, ihres Gefüges und ihrer Zusammensetzung wirksamen Faktoren als Meßwerte von $\rho$ und d durch einen Prozeßrechner erfaßt und errechnet, und dann über ein geeignetes Programm die Korrekturen für die einzelnen Beschichtungsparameter berechnet (siehe Fig. 1). Dadurch ist es möglich, sowohl die Bekeimung der Schicht als auch das Wachstum so zu beeinflussen, daß die Schicht im Endzustand die gewünschten elektrischen, strukturellen sowie gefügemäßigen Eigenschaften aufweist. Das Verfahren wird in der Halbleiter- und Dünnschicht-Technik verwendet.

FIG 1

Schichtdicke → Prozeß-rechner → Aufdampfrate
Widerstand → → Dotiergasdruck
→ Substrattemperatur
→ Legierungs-zusammensetzung

SIEMENS AKTIENGESELLSCHAFT        Unser Zeichen

Berlin und München        PA    80 P 7 0 0 6 E

Verfahren zur reproduzierbaren Herstellung metallischer Schichten.

Die vorliegende Patentanmeldung betrifft ein Verfahren zur reproduzierbaren Herstellung metallischer Schichten, wie sie insbesondere in der Halbleiter- und Dünnschicht-Technologie Anwendung finden, durch Steuerung des Beschichtungsprozesses, wobei der spezifische elektrische Widerstand in Abhängigkeit von der Schichtdicke bestimmt wird.

An die Toleranz und Konstanz der elektrischen Eigenschaften metallischer Schichten werden in der Halbleiter- und Dünnschicht-Technik extrem hohe Anforderungen gestellt. Der Temperaturkoeffizient des elektrischen Widerstandes, z.B. eines Dünnschicht-Widerstandes aus z.B. Chrom-Nickel, Aluminium-Tantal oder Tantal-Oxinitrid ($TaO_xN_y$) darf nur wenige $10^{-6} K^{-1}$ betragen. Ferner darf sich der Widerstandswert der oft nur 10 nm dicken Schichten innerhalb von vielen Jahren nur um wenige Prozent ändern.

Ein weiteres Beispiel ist die Herstellung von ß-Tantal-Schichten, die für Dünnschicht-Kondensatoren benötigt werden. Diese strukturelle Modifikation des $\alpha$-Tantals tritt nur bei dünnen Schichten unter ganz speziellen Keimbildungs- und Wachstumsbedingungen auf. Um gezielt diese Schichten herstellen zu können, darf weder die Zusammensetzung noch die Struktur oder das Gefüge der Schichten variieren.

Diese extremen Anforderungen machen es notwendig, das

Edt 1 Bla / 31.8.1980

Schichtwachstum praktisch von der ersten Monolage an zu verfolgen und gegebenenfalls auch zu steuern.

Aufgabe der Erfindung ist es daher, ein Verfahren anzugeben, welches sowohl über die Bekeimung der Schicht als auch über die Kristallisationsvorgänge während des Schichtwachstums Auskunft gibt. Ferner muß es möglich sein, daß bereits nach wenigen Monolagen Voraussagen über die zu erwartenden elektrischen Eigenschaften der Schicht gemacht werden können, weil dann noch während der Schichtherstellung die Keimbildung und das spätere Wachstum so beeinflußt werden können, daß die Schicht im Endzustand die gewünschten elektrischen Eigenschaften besitzt.

Bisher wurden für die reproduzierbare Herstellung dünner Metallschichten folgende Parameter als besonders wichtig erachtet: Substratreinigung, Endvakuum, Restgaszusammensetzung, Dotiergasdruck, Substrattemperatur, Zusammensetzung, Abscheiderate und Schichtdicke.

Um Schichten mit speziellen Eigenschaften zu erhalten, mußten bislang viele Versuche durchgeführt werden, um die optimale Kombination der oben erwähnten Parameter zu finden. Bei der fertigungsmäßigen Herstellung der Schichten muß dann darauf geachtet werden, daß diese Versuchsparameter möglichst exakt eingehalten werden. Nach der Fertigstellung der Schicht wird diese geprüft und erst dann kann entschieden werden, ob die Schicht die gestellten Bedingungen erfüllt. Bei den bekannten Verfahren treten je nach Toleranzgrenzen Ausschußraten von 1 bis 50% auf. Dadurch entstehen u.U. hohe Kosten, da die Substrate, bevor sie mit Metallschichten bedampft werden, oft schon viele Prozeßschritte durchlaufen haben.

Die Erfindung löst die gestellte Aufgabe der kontrollierten Herstellung metallisch leitender Schichten dadurch, daß die für das Wachstum der Schicht bezüglich ihrer Struktur, ihres Gefüges und ihrer Zusammensetzung wirksamen Faktoren durch laufende Messung des spezifischen elektrischen Widerstandes $\varrho$ in Abhängigkeit von der Schichtdicke $d$ unter Verwendung folgender Formeln

$$\langle \varrho(\overline{d}) \rangle = \frac{\overline{d}}{s} \int_0^s \frac{\varrho(d(x))}{d(x)} \, dx$$

mit $d(x) = \overline{d} + h \sin \frac{2\pi}{s} \cdot x$ (eindimensionale Fourier-Entwicklung mit einer Komponente)

und $\varrho(d(x)) = \varrho_\infty \left\{ 1 - \frac{3 l_\infty}{2\, d(x)} (1-p) \int_1^\infty \left( \frac{1}{t^3} - \frac{1}{t^5} \right) \frac{1 - e^{-\frac{d(x)}{l_\infty} \cdot t}}{1 - p e^{-\frac{d(x)}{l_\infty} t}} dt \right\}^{-1}$

mittels eines Prozeßrechners erfaßt und berechnet werden, wobei $\varrho_\infty$ = spezifischer elektrischer Widerstand der Schicht bei unendlicher Schicktdicke und gleicher innerer Struktur, $l_\infty$ = mittlere freie Weglänge bei unendlicher Schichtdicke und gleicher innerer Struktur, p = Spiegelungsparameter, h = mittlere Rauhigkeitsamplitude der Oberfläche, t = Integrationsvariable und s = Wellenlänge der periodischen Dickenschwankungen ist, daß in Abhängigkeit von den gemessenen Ist-Werten für $\varrho$ und d die Ist-Werte für $\varrho_\infty$, $l_\infty$, p und h laufend errechnet werden und mit den Soll-Werten von $\varrho_\infty$, d, $l_\infty$, p und h verglichen werden, daß die ermittelten Werte für die Einstellung der Beschichtungsparameter wie Substrattemperatur, Beschichtungsrate, Dotiergasdruck und Schichtzusammensetzung zur dynamischen Steuerung des Prozesses laufend verwendet werden, bis die gemessenen Ist-Werte mit den berechneten Soll-Werten übereinstimmen.

Folgende Überlegungen haben zu dem Verfahren nach der Lehre der Erfindung geführt:

Der spezifische elektrische Widerstand ist eine physikalische Größe, die u.a. äußerst empfindlich auf Gitterfehler, Verunreinigungen und strukturelle Änderungen reagiert. Da der Widerstand und die Schichtdicke relativ leicht meßbare Größen sind, ist der daraus errechenbare spezifische elektrische Widerstand der ideale Parameter, um eine metallische Schicht eindeutig zu charakterisieren. Die Erfindung macht sich die Theorien von K.Fuchs, H.H.Wills aus "Proc. Cambridge Phil. Soc. 34 (1938), Seiten 101-108, von E.H. Sondtheimer aus "Advances in Physics" 1 (1952), Seiten 1-41 und von Y.Namba aus "Jap. Journ. of Appl. Physics" 9 (1970), Seiten 1326-1329 zunutze, aus denen zu entnehmen ist, daß unter idealen Voraussetzungen die Schichtdickenabhängigkeit des spezifischen elektrischen Widerstandes exakt beschrieben werden kann.

Die Erfindung besteht darin, daß sich die im Realfall auftretenden Abweichungen des spezifischen elektrischen Widerstandes vom Idealverlauf auf Struktur- und Gefüge-Änderungen während der Herstellung zurückführen lassen. Solche Abweichungen bewirken eine Änderung von einem oder mehreren Ist-Werten für $\varrho_\infty$, $l_\infty$, p und h.

Die Verarbeitung dieser Theorien erfolgt so, daß bereits nach sehr wenigen Monolagen Ergebnisse über die Bekeimung der Schicht vorliegen und gleichzeitig der spezifische elektrische Widerstand einer wesentlich dickeren Schicht ($\varrho_\infty$) unter den momentan herrschenden Wachstumsbedingungen vorausberechnet werden kann.

Ferner ergeben sich noch Werte für die mittlere freie Weglänge $l_\infty$, den Spiegelungsparameter p (= Anteil der ohne Widerstandsverlust reflektierten Elektronen an der Oberfläche) und die Oberflächenrauhigkeitsamplitude h, welche vor allem bei sehr dünnen Schichten den Hauptbeitrag zur Widerstandserhöhung im Vergleich zur "unendlich" dicken Schicht liefert. Weichen die errechneten Werte für $\rho_\infty$, $l_\infty$, p und h von ihren Sollwerten ab, so können noch während der Schichtherstellung über den Prozeßrechner geeignete Parameter solange verändert werden (z.B. Substrattemperatur, Aufdampfrate, Dotiergasdruck), bis die Soll- und Ist-Werte übereinstimmen. Der Prozeßrechner gibt dabei sofort Auskunft, wie sich die Änderung eines Parameters auf den Endzustand der Schicht auswirkt. Damit ist sowohl eine Steuerung der Bekeimung als auch des Schichtwachstums möglich. Dies bedeutet, daß im Gegensatz zum momentanen Stand der Technik eine dynamische Steuerung des Aufdampfprozesses durchgeführt werden kann, so daß sich eine Endprüfung erübrigt.

Im folgenden wird die Erfindung anhand eines Ausführungsbeispiels für den apparativen Aufbau der Prozeßsteuerung (Fig.1 und 2) und Ausführungsbeispielen für Prozeßrechner-Steuerungen (Fig.3 bis 5) noch näher beschrieben.

Fig.1 zeigt den funktionellen Zusammenhang von Schichtdicke und Widerstand mit den Beschichtungsparametern in einem Diagramm.

Wie aus der Fig.1 zu entnehmen ist, muß für die Prozeßsteuerung während der Schichtherstellung laufend die aktuelle Schichtdicke und der dazugehörige Widerstand der Schicht gemessen werden. Dazu werden auf einem Referenzsubstrat vor der Schichtherstellung elektrische Zuführungen so angebracht, daß eine Widerstandsmessung mittels der 2- oder 4-Punktmessung bei definierter Probengeometrie möglich ist. Die Widerstandsmessung wird mit einem Meßsystem durchgeführt, welches über einen möglichst großen Widerstandsbereich (optimal: $10^{10}$-$10^{-6}$ $\Omega$) kontinuierlich mißt. Die Schichtdicke der Probe wird während der Beschichtung über ein geeichtes Schwingquarzsystem oder ein optisches Interferometersystem gemessen. Voraussetzung für das Widerstands- und Schichtdicken-Meßsystem ist, daß die Meßwerte über ein geeignetes Interface sofort nach der Messung an den Prozeßrechner digital übergeben werden können. Als Interface ist beispielsweise ein Analog-Digital-Wandler geeignet.

Aus mehreren möglichst schnell hintereinander durchgeführten Messungen ergibt sich eine Abhängigkeit des gemessenen spezifischen elektrischen Widerstandes von der Schichtdicke. Der Prozeßrechner berechnet dann über das mit Hilfe der im Kennzeichen des Patentanspruchs 1 angegebenen Formeln aufgestellte Programm die Korrekturen für die einzelnen Beschichtungsparameter, die aus dem in Fig.1 dargestellten Diagramm zu entnehmen sind.

Fig.2 zeigt ein Blockdiagramm einer rechnergesteuerten Beschichtungsanlage, wie sie für das Verfahren nach der Lehre der Erfindung verwendet wird.

Dabei gelten folgende Bezugszeichen:

1 Prozeßrechner
2 Widerstandsmessung
3 Schichtdickenmessung
4 Schwingquarz für die Schichtdickenmessung
5 Kühlung und Heizung für das Substrat
6 Temperaturregelung
7 Dosierventil für das Dotiergas
8 Ratensteuerung für Verdampfer 10 (z.B. Kupfer)
9 Ratensteuerung für Verdampfer 11 (z.B. Aluminium)

10 Verdampfer (z.B. für Kupfer)

11 Verdampfer (z.B. für Aluminium

12 Schwingquarz für Ratensteuerung 8

13 Schwingquarz für Ratensteuerung 9

14 Daten- und Steuerleitungen (z.B. Norm JEEE 488-1975)

Ausführungsbeispiele für Prozeßrechnersteuerung:

1. Kontrolle und Steuerung der Bekeimung und des Schichtwachstums bis $d < 10 \cdot l_\infty$

a) Über ein geeignetes Rechenprogramm werden laufend die vier Parameter $\rho_\infty$, $l_\infty$, p und h ermittelt. Je nach den Abweichungen wird eine Änderung eines oder mehrerer Herstellungsparameter durchgeführt.

b) Eine andere Möglichkeit ist die Messung des Einsetzens der ohmschen Leitfähigkeit in der Schicht. Ab dieser Dicke ist die Schicht zusammenhängend. Je früher eine Schicht zusammenhängend ist, desto größer ist die Keimdichte und umso kleiner sind die Kristallite.

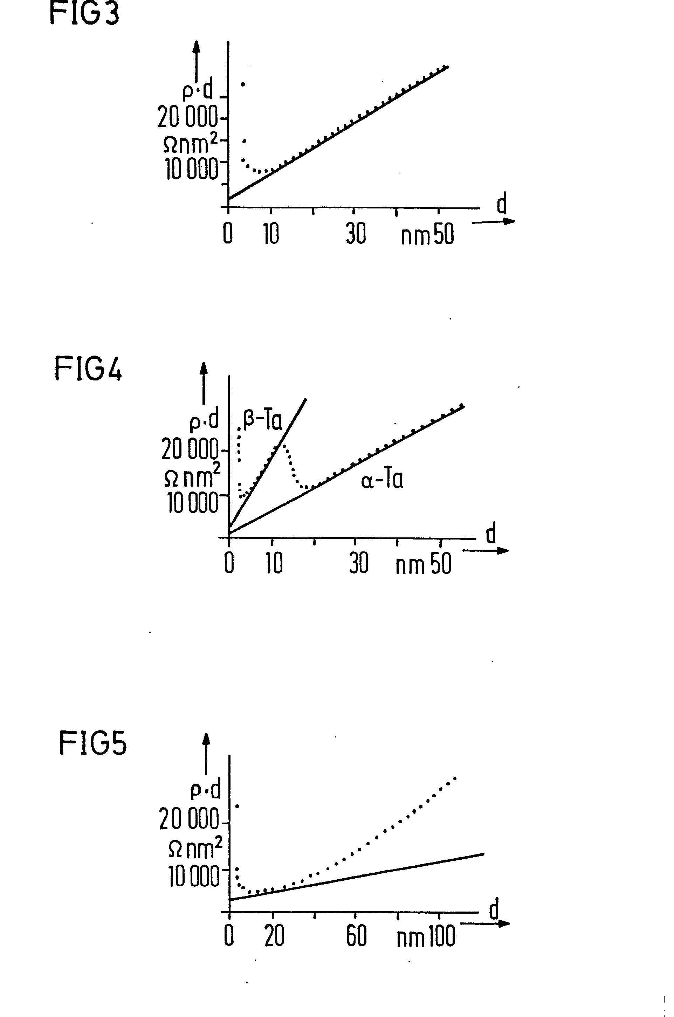

Solche Schichten besitzen gleichzeitig eine geringe Oberflächenrauhigkeit. Ein gutes Maß für das Einsetzen der ohmschen Leitfähigkeit ist, wie aus Fig.3 zu entnehmen ist, ein Minimum in der vom Prozeßrechner errechenbaren Schichtdickenabhängigkeit der Größe $\rho \cdot d$. Die Steigung entspricht $\rho_\infty$. Die Meßwerte (punktiert dargestellt) aus Fig.3 betreffen eine Aluminium/Kupfer-Schicht mit 46,4 Mol% Kupfer, hergestellt bei -160°C Substrattemperatur. Die errechneten Werte liegen bei $\rho_\infty$ = 87,5 $\mu\Omega cm$, $l_\infty$ = 0,8 nm, p = 0,6 und h = 1,8 nm.

Durch gezielte Steuerung des Minimums, wobei z.B. die Substrattemperatur oder die Aufdampfrate verändert wird, lassen sich Schichten mit definierter Oberflächenrauhigkeit oder Korngröße herstellen.

2. Kontrolle und Steuerung des Wachstums der Schichten für Schichtdicken $d > 10 \cdot l_\infty$

In diesem Schichtdickenbereich läßt sich die Abhängigkeit des gemessenen spezifischen elektrischen Widerstandes von der Schichtdicke gut durch die von Sondtheimer angegebene Näherung der Fuchs'schen Formel beschreiben, und zwar in der Form:

$$d \cdot \varsigma(d) = \varrho_\infty \cdot d + \frac{3}{8} \varrho_\infty \cdot l_\infty (1-p)$$

Alle Meßwerte sollten dann auf einer Geraden mit der Steigung $\varrho_\infty$ liegen, während der Ordinatenabschnitt durch die Größe $\frac{3}{8} \varrho_\infty \, l_\infty \, (1-p)$ gegeben ist.

Tritt während der Schichtherstellung ein Knick in der Geraden auf, so kann dies auf strukturelle Änderungen zurückgeführt werden, z.B. der Kristallisation eines amorphen Materials oder, wie aus Fig.4 zu entnehmen ist, dem Übergang von ß- zu $\alpha$-Tantal bei der Herstellung einer reinen Tantalschicht bei $300^\circ$C. Die punktierte Linie zeigt wieder den Verlauf der Meßwerte.

Ergibt sich aus den Meßwerten jedoch eine laufende Änderung der Steigung zu größeren $\varsigma \cdot d$-Werten hin — wie aus Fig.5 am Beispiel einer reinen Aluminium-Aufdampfschicht zu entnehmen ist —, so kommen dafür zwei Ursachen in Frage:

1. Die Rauhigkeit der Schicht nimmt als Folge eines zu starken Kornwachstums zu.
2. Es entstehen Risse in der Schicht.

Diese Ergebnisse zeigen, wie empfindlich der spezifische elektrische Widerstand auf spezielle Veränderungen in der Schicht reagiert, so daß es möglich ist, durch Variation des richtigen Parameters wieder die Wachstumsbedingungen einzustellen, die den gewünschten $\varrho_\infty$-Wert liefern.

Das Verfahren nach der Lehre der Erfindung zur Steuerung
der Bekeimung und des Schichtwachstums ist sowohl für
Aufdampf- als auch für Sputter-Prozesse anwendbar.

4 Figuren
6 Patentansprüche

80 P 7006

Patentansprüche:

1. Verfahren zur reproduzierbaren Herstellung metallischer Schichten, wie sie insbesondere in der Halbleiter- und Dünnschicht-Technologie Anwendung finden, durch Steuerung des Beschichtungsprozesses, wobei der spezifische elektrische Widerstand in Abhängigkeit von der Schichtdicke bestimmt wird, dadurch g e k e n n - z e i c h n e t , daß die für das Wachstum der Schicht bezüglich ihrer Struktur, ihres Gefüges und ihrer Zusammensetzung wirksamen Faktoren durch laufende Messung des spezifischen elektrischen Widerstandes $\rho$ in Abhängigkeit von der Schichtdicke d unter Verwendung folgender Formeln

$$\langle \rho(\overline{d}) \rangle = \frac{\overline{d}}{s} \int_0^s \frac{\rho(d(x))}{d(x)} \, dx$$

$$\text{mit } d(x) = \overline{d} + h \sin \frac{2\pi}{s} x$$

$$\text{und } \rho(d(x)) = \rho_\infty \left\{ 1 - \frac{3}{2} \frac{l_\infty}{d(x)} (1-p) \int_1^\infty \left( \frac{1}{t^3} - \frac{1}{t^5} \right) \frac{1 - e^{-\frac{d(x)}{l_\infty} t}}{1 - p e^{-\frac{d(x)}{l_\infty} t}} \, dt \right\}^{-1}$$

mittels eines Prozeßrechners erfaßt und berechnet werden, wobei $\rho_\infty$ = spezifischer elektrischer Widerstand der Schicht bei unendlicher Schichtdicke und gleicher innerer Struktur, $l_\infty$ = mittlere freie Weglänge bei unendlicher Schichtdicke und gleicher innerer Struktur, p = Spiegelungsparameter, h = mittlere Rauhigkeitsamplitude der Oberfläche, t = Integrationsvariable und s Wellenlänge der periodischen Dickenschwankungen, daß in Abhängigkeit von den gemessenen Ist-Werten für $\rho$ und d die Ist-Werte für $\rho_\infty$, $l_\infty$, p und h laufend errechnet werden und mit den Soll-Werten von $\rho_\infty$, d, $l_\infty$, p und h verglichen werden, daß die ermittelten Werte für die Einstellung der Beschichtungsparameter wie Substrattemperatur, Beschichtungsrate, Dotiergasdruck und Schichtzusammensetzung zur dynamischen Steuerung des Prozesses laufend verwendet werden, bis die gemessenen Ist-Werte mit den berechneten Soll-Werten übereinstimmen.

2. Verfahren nach Anspruch 1, dadurch g e k e n n - z e i c h n e t , daß die Meßwerte für Schichtdicke und Widerstand direkt oder mittels eines Analog-Digital-Wandlers in den Prozeßrechner eingegeben werden.

3. Verfahren nach Anspruch 1 und/oder 2, dadurch g e - k e n n z e i c h n e t , daß die Messung des spezifischen elektrischen Widerstandes über ein Referenzsubstrat mittels der 2-Punkt- oder 4-Punkt-Messung vorgenommen wird, wobei das Meßsystem einen Widerstandsbereich von $10^{10}$ bis $10^{-6}$ $\Omega$ aufweist.

4. Verfahren nach einem der Ansprüche 1 bis 3, dadurch g e k e n n z e i c h n e t , daß die Schichtdickenmessung über ein geeichtes Schwingquarzsystem vorgenommen wird.

5. Verfahren nach einem der Ansprüche 1 bis 3, dadurch g e k e n n z e i c h n e t , daß die Schichtdickenmessung mittels eines optischen Interferometers durchgeführt wird.

6. Verfahren nach den Ansprüchen 1 bis 5, dadurch g e - k e n n z e i c h n e t , daß die Schichten durch Aufdampf- bzw. Sputterprozesse hergestellt werden.

## FIG1

Schichtdicke → Prozeß-rechner → Aufdampfrate

Widerstand → → Dotiergasdruck

→ Substrattemperatur

→ Legierungs-zusammensetzung

## FIG2

0033507

FIG3

FIG4

FIG5